# EUROPÄISCHE PATENTSCHRIFT

(11) **EP 1 980 644 B1**
(45) Veröffentlichungstag und Bekanntmachung des Hinweises auf die Patenterteilung: **02.09.2009**
(21) Anmeldenummer: 07007108.9
(22) Anmeldetag: 04.04.2007
(51) Int. Cl.: C23C 14/02, C23C 14/56

(54) **Vorrichtung und Verfahren zur Beschichtung eines Kunststoffsubstrates**
Apparatus and method for coating of a plastic substrate
Appareil et procédé de revêtement d'un substrate plastique

(43) Veröffentlichungstag der Anmeldung: 15.10.2008
(73) Patentinhaber: Applied Materials, Inc., Santa Clara, CA 95054 (US)
(72) Erfinder: Sauer, Peter, 36381 Schlüchtern (DE); Lotz, Hans-Georg, Dr., 63584 Gründau-Rothenbergen (DE)
(74) Vertreter: Bockhorni & Kollegen

(56) Entgegenhaltungen:
- EP-A- 0 386 459
- EP-A1- 0 475 145
- US-B1- 6 171 714
- US-B1- 6 194 076
- FRONZ V: "KUPFER DIREKT AUF POLYIMID" METALLOBERFLACHE, CARL HANSER VERLAG. MUNCHEN, DE, Bd. 44, Nr. 5, 1. Mai 1990 (1990-05-01), Seiten 237-240, XP000170829

## Beschreibung

Die Erfindung betrifft ein Verfahren zur Beschichtung eines Kunststoffsubstrates mit mindestens einer Metallschicht, insbesondere Kunststofffolie für flexible, gedruckte Leiterbahnen, wobei vor dem Aufbringen einer ersten Schicht auf eine zu beschichtende Oberfläche des Kunststoffsubstrates eine nicht beschichtende Vorbehandlung dieser Oberfläche vorgenommen wird.

Die Erfindung betrifft außerdem eine Bandbeschichtungsanlage zur Beschichtung einer Kunststofffolienbahn mit mindestens einer Metallschicht, insbesondere für flexible, gedruckte Leiterbahnen, wobei eine Vorbehandlungseinheit für eine nicht beschichtende Vorbehandlung einer Oberfläche der Kunststofffolienbahn vorgesehen ist, die in Transportrichtung der Kunststofffolienbahn durch die Bandbeschichtungsanlage einer ersten Beschichtungssektion vorgeordnet ist.

Verfahren und Vorrichtung dieser Art dienen zur Beschichtung von Kunststoffen mit meist mehreren Metallschichten, vorzugsweise durch Sputtern. Die derart metallisierten Kunststoffsubstrate sind u. a. als Kunststofffolien Ausgangsprodukte für die Herstellung von flexiblen, gedruckten Leiterbahnen (flexible printed circuit board), wie sie in Monitoren, Kameras, Handys etc. verwendet werden. Ein wesentlicher Anwendungsfall sind auch Druckerkartuschen von Druckern, in denen umfangreiche flexible Leiterbahnen als Schaltfläche benötigt werden.

Diese Anwendungen stellen neben den Anforderungen an eine hohe mechanische Beanspruchbarkeit auch hohe Anforderungen hinsichtlich der Temperaturstabilität. So müssen die auf die Kunststofffolien aufgebrachten metallischen Topographien lötbar sein, so dass kurzzeitige Temperaturbeanspruchungen bis etwa 400° auftreten. Angewandt in elektronischen Bauteilen mobiler Technik, wie beispielsweise in Autos und Flugzeugen, sind die Leiterbahnen außerdem klimabedingten Beanspruchungen wie Feuchtigkeitsanfall und erheblichen Temperaturwechselbeanspruchungen ausgesetzt. Permanente mechanische und thermische Wechselbeanspruchungen bewirken derartige Gefügespannungen im Schichtsystem, die bei ungenügender Haftung der metallischen Schichten auf der Oberfläche der Kunststofffolie zur frühzeitigen Delamination des Schichtenmaterials führt und damit die Qualitätseigenschaften der beschichteten Kunststofffolien unerwünscht mindern.

Zur Verbesserung der Haftfestigkeit der auf das Kunststoffsubstrat aufgebrachten Metallschichten ist es bekannt, die Oberfläche der Kunststoffsubstrate vor dem eigentlichen Beschichtungsvorgang mit einem Plasma vorzubehandeln. Das Plasma wird durch Ionisierung eines Gases oder eines Gasgemisches erzeugt, wobei unter Energieeintrag positiv geladene Gasionen und freie Elektronen entstehen. Sodann wird das Plasma mit der Oberfläche des Kunststoffsubstrates in direkten Kontakt gebracht. Bei dieser Plasmabehandlung werden Verunreinigungen sowie geringste Feuchtigkeitsfilme von der Oberfläche des Kunststoffsubstrates entfernt. Zumeist wird hierbei allerdings auch die Oberflächenrauhigkeit erhöht.

Eine nicht beschichtende Vorbehandlung im Sinne der Erfindung meint eine Vorbehandlung, bei der im Wesentlichen kein Schichtmaterial auf die Oberfläche des Kunststoffsubstrates abgetragen wird. Es ist natürlich verfahrens- und fertigungstechnisch bedingt nicht ausgeschlossen, dass einzelne Fremdatome, auch Metallatome, die im Plasma vorhanden sein können, an die Oberfläche des zu behandelnden Kunststoffsubstrates gelangen können und sich an diese anlagern. Dabei handelt es sich jedoch nicht um ein Beschichten der Oberfläche.

In der Druckschrift CH 682821 A5 wird ein Verfahren zum Behandeln einer Substratoberfläche, insbesondere Kunststofffolien für Verpackungszwecke, vor dem Aufbringen einer Permeationssperre aus anorganischem Material beschrieben, bei der die Substratfläche der Einwirkung eines Plasmas ausgesetzt wird. Das Plasma wird in einer ersten Variante mit einer Hochfrequenz-Hohlanode und einem auf Erdpotential liegender Elektrode, hier der Kunststofffolie, erzeugt, wobei sich die Hohlanode über die gesamte Breite der Folienbahn erstreckt. Auf der Substratfläche bildet sich eine Biasspannung aus, wodurch die Ionen des Plasmagases zusätzlich in Richtung der Substratoberfläche beschleunigt werden. Die Flächenleistungsdichte liegt gemäß einer bevorzugten Ausführung bei etwa 3 W/cm². In einer zweiten Variante wird das Plasma mit geometrisch ebenso erstreckten Magnetronkathoden erzeugt. Die Magnetronkathoden können mit am Innenpol geschwächtem Magnetfeld ausgebildet sein, mit welchem die Plasmadichte am Substrat erhöht wird. Die Magnetronkathoden werden mit Hochfrequenzwechselspannung oder Gleichspannung versorgt. Die mit der Substratoberfläche in Berührung kommenden energiereichen Ionen des Plasmas bewirken eine Reinigung und gleichzeitig eine chemische Anregung und Aktivierung der Oberfläche, durch die auch bei hoher Durchlaufgeschwindigkeit des Substrates durch die Vakuumkammer eine bessere Verbundhaftung der Permeationssperre mit der Kunststofffolie erreicht wird.

Die Druckschrift EP 0 386 459 A1 beschreibt ein Verfahren zur Herstellung von Dünnschichtschaltungen auf einem Substrat mit einer nichtleitenden Oberfläche, bei dem vor dem Aufsputtern einer haftvermittelnden Grundmetallisierung die Oberfläche des Substrats mittels einer Plasmabehandlung vorgereinigt wird. In einer bevorzugten Ausführung wird ein Substrat aus Keramik mit einer Polyimidschicht bedeckt, die die nichtleitende Oberfläche bildet. Die Oberfläche wird zunächst sorgfältig gewaschen und entfettet und anschließend in einer Vakuumanlage einem Argon-Plasma unterzogen. Bei der auch als Sputterätzen bezeichneten Plasmabehandlung werden Verschmutzungen, welche nach dem Waschen und Entfetten noch an der Oberfläche haften, entfernt und die Oberfläche der Polyimidschicht aufgeraut, bevor die Grundmetallisierung aus CuCr oder NiV mit einer Dicke von 0,2-1 µm aufgesputtert wird. Dabei sollte ausführungsgemäß das Sputterätzen etwa 5 Minuten andauern. Im Ergebnis wird eine haftfeste Metallisierung auf Polyimidschichten oder Polyimidsubstrate erzielt, wobei der häufig verwendete Kupfer-Polyimid-Verbund im Peeltest eine Haftfestigkeit von bis zu 1,5 N/mm zeigt.

Die Druckschrift US 5 484 517 beschreibt ein Verfahren zum Erzeugen eines Multi-Element-Dünnschichtsensors auf einer Polyimidfolie. Die Herstellung des Multi-Element-Dünnschichtsensors umfasst mehrere Reinigungsschritte. Zunächst wird die Oberfläche der Polyimidfolie mehrfach mittels einer Ultraschallreinigung in einer heißen Lösung aus entionisiertem Wasser und Reinigungsmittel bei mindestens 180° F gereinigt und mit entionisiertem Wasser bei Raumtemperatur nachgespült. Nach dem Trocknen in einem Ofen bei annähernd 350°F wird die Folie in einer Vakuumkammer unter kontinuierlichem Ionenstrahlbeschuss mit Argon-Ionen gereinigt während gleichzeitig Nickel auf der Oberfläche aufgedampft wird. In einer bevorzugten Ausführung verlaufen beide Vorgänge simultan bis die Nickelschichtdicke schichtdicke z.B. eine Stärke von ca. 200 Ångström hat. Danach wird die Ionenstrahlreinigung mit dem Argongas unterbrochen und die Nickelbedampfung fortgesetzt, bis die Nickelschicht eine Dicke von ca. 2500 Ångström erreicht hat. Hierbei handelt es sich um ein ionenstrahl-unterstütztes Beschichten (Ion Beam Assisted Deposition, IBAD), bei dem das Substrat während des Beschichtungsvorgangs zusätzlich mit einem Ionenstrahl behandelt wird. Dies bewirkt eine verbesserte Adhäsion der aufzutragenden Nickelschicht und eine reduzierte Spannung und mehr Festigkeit in der aufgetragenen Schicht. Da der Ionenbeschuss hier vornehmlich einen Beschichtungsvorgang unterstützt, betrifft die Behandlungsmethode keine nicht beschichtende Vorbehandlung des Kunststoffsubtrates im Sinne der Erfindung, so dass wohl die vorbeschriebene EP 0 386 459 A1 als nächstliegender Stand der Technik anzusehen ist.

Die Druckschrift US 6 171 714 B1 offenbart einen flexiblen Schichtenstoff aus Polymerfolie, einer Nickel-Ankerschicht und einer Kupfer-Impfschicht sowie ein Verfahren zur Herstellung eines solchen Schichtenstoffes. Die Oberfläche der Polymerfolie wird einer Plasmabehandlung unterzogen, wobei das verwendete Plasma mittels einer nicht metallisierenden Kathode erzeugt wird und aus ionisiertem Sauerstoff besteht. Dabei werden keine wesentlichen Mengen an Metall oder Metalloxid (<= 0,1 Gew.-% ) auf der Oberfläche der Polymerfolie abgeschieden. Das Plasma wird über eine wirksame Dauer und in einer ausreichenden Intensität angewendet, um die Oberfläche chemisch zu modifizieren, Oberflächenverunreinigungen zu entfernen und/oder die Oberflächenrauigkeit zu erhöhen Das Plasmagas kann Sauerstoff, Luft oder eine gasförmige Mischung mit einer beliebigen Sauerstoffkonzentration sein. Die Entladungsenergiedichte liegt im Bereich von etwa 0,1 bis etwa 8 W/cm², in einer Ausführungsform etwa 0,17 bis etwa 6,2 W/cm² und in einer weiteren Ausführungsform etwa 0,34 bis etwa 2,41 W/cm).

Aus der Druckschrift US 6 194 076 B1 ist ein kupferbeschichtetes Polyimidsubstrat bekannt, wobei das Kupfer in zwei Schritten auf die polyimide Oberfläche aufgebracht wird. In einem ersten Schritt wird die Oberfläche des polyimiden Substrates einem reaktiven Gasplasma ausgesetzt, das ein bestimmtes Niveau des Ionenbeschusses liefert, welches ausreicht, wenigstens einen Teil der Imide-Gruppen auf der Oberfläche aufzuspalten und reaktive Karboxylatgruppen, Karbonylgruppen und andere Karbonsauerstoff-funktionale Gruppen auf der Oberfläche zu bilden. Im nachfolgenden Schritt wird dann eine Kupferschicht auf die chemisch modifizierte Oberfläche abgelegt. Das Niveau des für die Modifizierung der Oberfläche verwendeten Ionenbeschusses resultiert aus Plasmazuständen, die sich in einem Wert von mindestens 5 x 10¹⁷ eV/Liter-atm ausdrücken.

In der Anwendung der metallisierten Kunststoffsubstrate, insbesondere als flexible Leiterbahnen, hat es sich gezeigt, dass die bekannten Methoden für die Vorbehandlung des Kunststoffsubstrates nicht geeignet sind, die Haftfestigkeit der aufgebrachten Metallschichten im ausreichenden Maße zu gewährleisten.

Ausgehend von dem bekannten Stand der Technik liegt der Erfindung die Aufgabe zugrunde, ein Verfahren der eingangs genannten Art bereitzustellen, mit welchem die Haftung von Metallschichten auf einem Kunststoffsubstrat verbessert wird. Außerdem soll eine Bandbeschichtungsanlage bereitgestellt werden, mit welcher ein solches Verfahren umsetzbar ist.

Die Aufgabe wird durch ein Verfahren mit den Merkmalen des Patentanspruches 1 gelöst. Die in den Unteransprüchen 2 bis 15 aufgeführten Maßnahmen beschreiben vorteilhafte Ausgestaltungen des erfindungsgemäßen Verfahrens.

Die Aufgabe wird außerdem durch eine Bandbeschichtungsanlage nach den Merkmalen des Patentanspruches 16 gelöst. Vorteilhafte Ausgestaltungen der erfindungsgemäßen Bandbeschichtungsanlage ergeben sich aus den abhängigen Unteransprüchen 17 bis 24.

Erfindungsgemäß erfolgt die nicht beschichtende Vorbehandlung des Kunststoffsubstrates in zwei Stufen, nämlich in einer ersten Stufe, in der die Oberfläche des Kunststoffsubstrates mit einem nichtreaktiven, energiearmen Plasma gereinigt wird,
wobei das Plasma eine Leistungsdichte in einem Bereich von 0,05 bis 1 W/cm² aufweist, und in einer zweiten Stufe, in der die Oberfläche des Kunststoffsubstrates durch eine reaktive, energiereiche Ionenbestrahlung aktiviert wird, wobei die Ionenbestrahlung eine Leistungsdichte in einem Bereich von mehr als 1 bis 10 W/cm² aufweist.

Überraschender Weise hat sich gezeigt, dass durch die erfindungsgemäße stufenweise Vorbehandlung des Kunststoffsubstrates in der Reihenfolge und Kombination der beanspruchten Prozessparameter eine Haftung der Metallschichten auf dem Kunststoffsubstrat, insbesondere auf Kunststofffolien, bis zur Zerreisfestigkeit des Kunststoffes erreichbar ist.

Nach dem bekannten Stand der Technik bezüglich der Plasmavorbehandlung war davon auszugehen, dass eine weitere Vorbehandlung der Oberfläche im Nachgang einer Plasmabehandlung nicht sinnvoll erschien, da keine weiteren Vorteile über den bisher bekannten Reinigungs- und Anrauungseffekt zu erwarten waren. Vielmehr war davon auszugehen, dass die mit der Plasmabehandlung erreichte Vorreinigung bzw. Oberflächenstruktur durch zusätzliche Vorbehandlungsmaßnahmen eher unerwünscht gestört wird.

Das erfindungsgemäß in der ersten Vorbehandlungsstufe angewandte Plasma ist energetisch und chemisch jedoch so eingestellt, dass die Plasmabehandlung allein dazu erfolgt, mögliche Verunreinigungen und Feuchtigkeit auf dem Kunststoffsubstrat zu beseitigen. Eine Oberflächenbearbeitung bei der die Oberfläche aufgeraut wird, wird bei der ersten Vorbehandlungsstufe gerade nicht bezweckt und daher vermieden. Mit der Plasmaanwendung kommt es an der Oberfläche bzw. den oberflächennahen Bereichen zu Wechselwirkungen zwischen den Teilchen des Plasmas und denen des Kunststoffsubstrates. Je nach Wahl der Prozessparameter (Art der Plasmaerzeugung, Spannung, Strom, Art und Druck des Prozessgases) können diese Wechselwirkungen entweder eine Entfernung von an der Substratoberfläche adsorbierten Teilchen (z. B. H₂O), eine Anregung von Oberflächenatomen, das Aufbrechen von Verbindungen an der Oberfläche oder eine Modifizierung der Substratoberfläche durch chemische Reaktionen ergeben. Mit Prozessparametern, die das erfindungsgemäß vorgesehene energiearme, nicht reaktive Plasma bewirken, lässt sich einstellen, dass nur die Entfernung von an der Oberfläche adsorbierten Teilchen bevorzugt auftritt. Zur Realisierung des nichtreaktiven Plasmas wird ein Edelgas, vorzugsweise Argon, als Prozessgas eingesetzt.

Eine besonders energiearme Plasmavorbehandlung, bei der in vorteilhafter Weise das Kunststoffsubstrat nur sanft behandelt und die Oberflächenstruktur nicht aufgebrochen bzw. angeraut wird, erzielt ein niederenergetisches Plasma mit einer besonders geringen Leistungsdichte in einem Bereich von 0,05 bis 1 W/cm².

Vorzugsweise wird ein Plasma durch Glimmentladung gezündet, welches sowohl von einer Gleichstrom- als auch von einer Wechselstromquelle aufrechterhalten werden kann, wobei die Glimmentladung mit einem niedrigen Spannungspotential von 01 kV bis 1 kV betrieben wird.

Erst in der zweiten Vorbehandlungsstufe wird die Oberfläche des Kunststoffsubstrates durch eine reaktive, energiereiche Ionenbestrahlung dieser Oberfläche aktiviert. Hier erfolgt unter intensivem und gerichtetem Ionenbeschuss eine gezielte Abtragung von Oberflächenatomen. Die Erfindung geht dabei davon aus, dass die Art und Weise und der Umfang der Abtragung wesentlich von der Ionenenergie, erzeugt durch die Ionenmasse und deren Beschleunigung, auf die Oberfläche abhängt. Die erfindungsgemäße Ionenbestrahlung weist daher eine hohe Leistungsdichte auf, insbesondere eine Leistungsdichte in einem Bereich von mehr als 1 bis 10W/cm², vorzugsweise mehr als 1 bis 5 W/cm², insbesondere mehr als 1 bis 3 W/cm².

Die Ionenstrahlung wird mittels einer Ionenquelle bereitgestellt, in der durch eine elektrische Gasentladung, vorzugsweise mit Argon als Arbeitsgas, positiv geladene Ione erzeugt werden, die nachfolgend eine zusätzliche elektrische Beschleunigung erfahren und mit hohem Impuls auf das Kunststoffsubstrat gerichtet werden. Vorzugsweise wird die Ionenquelle dazu mit einem hohen Spannungspotential von 1kV bis 3 kV betrieben. Die energiereichen Ionen treffen mit hoher Energie auf der Oberfläche des Kunststoffsubstrates auf oder dringen in die Oberflächenstruktur ein,
wobei sie ihre kinetische Energie an die Oberflächenstruktur abgeben. Dabei finden Wechselwirkungen mit den Atomen an der Oberfläche des Kunststoffsubstrates statt, die bei hohem Energieeintrag durch die Ionen nicht nur zur Anregung und Ionisation dieser Festkörper-Atome sondern auch zur Defekt- und Fehlstellenbildung in der Oberflächenstruktur und zum Abtrag (Zerstäubung) von Atomen aus der Oberfläche führen, auch ioneninduzierte Oberflächenzerstäubung (sputtering) genannt. In dieser Weise wird die Oberfläche nicht nur für die nachfolgenden Beschichtungsvorgänge intensiv aufgeraut sondern auch eine Aktivierungsenergie für die nachfolgenden chemischen Reaktionen mit dem Schichtmaterial bereitgestellt, so dass eine verbesserte Schichtadhäsion der aufzutragenden Schicht gewährleistet wird.

In Verbindung mit einer erfindungsgemäßen reaktiven Atmosphäre der Ionenbestrahlung, bei der Reaktionsgase, vorzugsweise Sauerstoff und/oder Stickstoff dem Ionenstrahl zugeleitet werden, treffen gleichzeitig reaktionsfähige Gasatome und Gasione auf die Oberflächenstruktur auf und werden von dieser adsorbiert, wobei die reaktionsfreudigen Gasmoleküle in die Oberflächenstruktur eingebaut werden, so dass die nachfolgende chemische Reaktion des Kunststoffsubstrates mit dem aufzutragenden Schichtmaterial besonders gefördert wird.

Im Ergebnis wird die Schichthaftung des nachfolgend aufgebrachten metallischen Schichtmaterials so gut, dass bei einer Haftfestigkeitsprüfung der auf diese Weise hergestellten Verbundfolie durch einen Peeltest keine Delamination der Schichten erfolgt, sondern das Verbundmaterial zuvor in sich reißt. Außerdem wird einer bisher auftretenden Abschwächung der Haftfestigkeit unter zyklischen Klimaschwankungen, wie in Klimatests simuliert, erfolgreich entgegen gewirkt, so dass von einer verbesserten Widerstandsfähigkeit des Verbundstoffes gegenüber äußeren Einflüssen ausgegangen werden kann.

Die Energiedichte des Ionenstrahls auf der Oberfläche des Kunststoffsubstrates wird erhöht, wenn die Ionenquelle einen bandartigen Ionenstrahl erzeugt, der derart fokussiert wird, dass der Ionenstrahl in Art einer Linie auf die Oberfläche des Kunststoffsubstrates auftrifft. Die Fokussierung wird besonders in Zusammenhang mit einem bevorzugten Spannungspotential der Ionenquelle von mindestens 1kV erreicht. In einer Relativbewegung des Kunststoffsubstrates zu dem derart gestalteten Ionenstrahl kann die Oberfläche des Kunststoffsubstrates somit sowohl gleichmäßig als auch intensiv bestrahlt werden. Für eine kontinuierliche Bestrahlung des Kunststoffsubstrates erfolgt die lineare Projizierung des fokussierten Ionenstrahls vorzugsweise quer zu einer Transportrichtung des Kunststoffsubstrates.

In einer bevorzugten Ausführung kommt als Kunststoffsubstrat eine Folie aus Polyimid zur Anwendung, da sie besonders widerstandsfähig gegen mechanische und thermische Beanspruchungen ist, was sich natürlich auch positiv auf die Haftbeständigkeit der Metallschichten in der Endausführung als Verbundfolie auswirkt. Daher kommt Polyimidfolie vornehmlich für flexible Schalt- und Leiterbahnen zum Einsatz.

Die Folie weist vorzugsweise eine Foliendicke in einem Bereich von 12,5 µm bis 50 µm auf, da in diesem Bereich die erforderlichen Folieneigenschaften, wie zum Beispiel eine hohe Reißfestigkeit, gegenüber den nicht unerheblichen Materialkosten des Kunststoffmaterials in einem wirtschaftlich günstigen Verhältnis zu einander stehen.

Das erfindungsgemäße Verfahren wird besonders vorteilhaft für die Vorbehandlung von Kunststofffolien angewandt, auf die nachfolgende Schichten durch Sputtern aufgebracht werden. In einer vorteilhaften Ausführungsform wird in einem ersten Beschichtungsschritt eine Haftvermittlerschicht durch Aufsputtern aufgebracht,
wobei als Schichtmaterial vorzugsweise Chrom (Cr), Nickel(Ni), Nickelchrom (NiCr) oder Chromtitan (CrTi) mit einer Schichtdicke von vorzugsweise 2 nm bis 40 nm ausgebildet wird. Bevorzugt wird nachfolgend eine Metallschicht aus vorzugsweise Kupfer oder Kupferlegierung aufgesputtert, wobei die Schichtdicke vorzugsweise in einem Bereich von 150 µm bis 300 µm ausgebildet wird.

Erfindungsgemäß wird außerdem eine Bandbeschichtungsanlage vorgeschlagen, bei der die Vorbehandlungseinheit eine erste Behandlungssektion zur Reinigung der Oberfläche der Kunststofffolienbahn mit einem nichtreaktiven, energiearmen Plasma mit einer Leistungsdichte in einem Bereich von 0,05 bis 1 W/cm² aufweist, und eine in Transportrichtung nachfolgende zweite Behandlungssektion zur Aktivierung der Oberfläche der Kunststofffolienbahn mit einem reaktiven, energiereichen Ionenstrahl mit einer Leistungsdichte in einem Bereich von mehr als 1 bis 10 W/cm² aufweist. Mit dieser Bandbeschichtungsanlage kann das erfindungsgemäße Verfahren unter Verwendung von Kunststofffolienbahnen mit den vorbeschriebenen Vorteilen in-line ausgeführt werden.

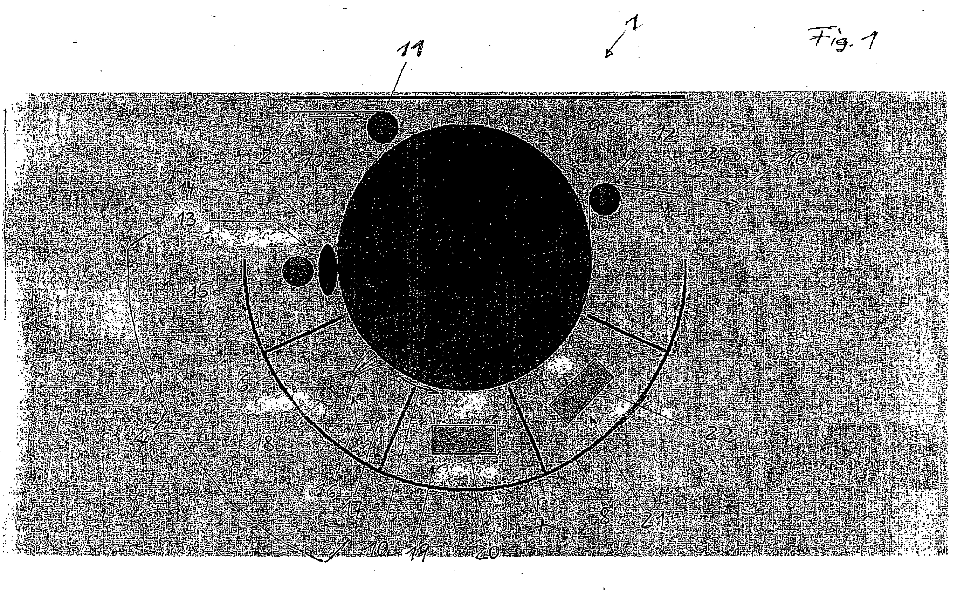

Weitere Merkmale und Vorteile der Erfindung, insbesondere der erfindungsgemäßen Bandbeschichtungsanlage, ergeben sich aus der nachfolgenden Beschreibung eines bevorzugten Ausführungsbeispiels und der beigefügten Zeichnung in Fig. 1.

Die Fig. 1 zeigt in einer schematischen Darstellung die wesentlichsten Elemente einer Bandbeschichtungsanlage 1 nach dem Ausführungsbeispiel zur Beschichtung einer Kunststofffolienbahn 2 mit Metallschichten. Die mit der Bandbeschichtungsanlage 1 herzustellende Verbundfolie 3 wird insbesondere als Ausgangsprodukt für flexible, gedruckte Leiterbahnen verwendet. Die Bandbeschichtungsanlage 1 weist eine Vorbehandlungseinheit 4, für eine nicht beschichtende Vorbehandlung der Kunststofffolienbahn 2 auf, bestehend aus einer ersten Behandlungssektion 5 und einer zweiten Behandlungssektion 6. Die Bandbeschichtungsanlage 1 weist außerdem eine erste und zweite Beschichtungssektion 7, 8 zur Beschichtung der Kunststofffolienbahn 2 auf, wobei die vorgenannten Sektionen 5, 6, 7, 8 nacheinander um eine zentrale Beschichtungswalze 9 angeordnet sind, welche als Substratträger dient. Die Kunststofffolienbahn 2 aus beispielsweise Polyimidfolie 2 mit einer Dicke von 38 µm wird von einem nicht dargestellten Wickel über ebenfalls nicht dargestellte Breitstreck- und Zugwalzen in Pfeilrichtung 10, die die Transportrichtung 10 der Kunststofffolienbahn 2 markiert, über eine erste Umlenkwalze 11 auf die Beschichtungswalze 9 geführt. Die Kunststofffolienbahn 2 wird nach der Evakuierung der Sektionen 5, 6, 7, 8 der Bandbeschichtungsanlage 1 entlang des Umfangs der Beschichtungswalze 9 mit einer Geschwindigkeit von 1,3 m/min zunächst durch die Vorbehandlungseinheit 4 und nachfolgend durch die erste und zweite Beschichtungssektion 7, 8 durchgeführt und verlässt anschließend über eine zweite Umlenkwalze 12 die Bandbeschichtungsanlage 1 zu einem nicht dargestelltem weiteren Wickel.

In der ersten Behandlungssektion 5 befindet sich eine Glimmentladevorrichtung 13 zur Reinigung der Oberfläche der Polyimidfolie 2 mit einem Plasma 14. Die Glimmentladevorrichtung 13 weist dazu ein Magnetron mit einer Glimmkathode 15, beispielsweise aus Edelstahl, Titan oder Molybdän, auf. Die Glimmentladevorrichtung 13 wird mit einem niedrigen Spannungspotential von 0,5 kV bei einem Stromfluss von 0,3 A betrieben, so dass ein niederenergetisches Plasma 14 mit einer Leistungsdichte von 0,15 W/cm² erzeugt wird. Die Glimmentladevorrichtung 13 ist dabei so angeordnet, dass das erzeugte Plasma 14 direkt an der Polyimidfolie 2 anliegt. Als Arbeitsgas zur Erzeugung eines nichtreaktiven Plasmas 14 wird Argon mit einem der Leistungsdichte entsprechendem Gasvolumenstrom von 200 sccm (Standard cm³/min) verwendet, wobei der Gasdruck in der Behandlungssektion 5 ca. 2 x 10⁻² mbar beträgt. Dabei ist die eingestellte Leistungsdichte des Plasmas 14 auf die vorgegebene Bandgeschwindigkeit des Foliendurchlaufes abgestimmt, die hauptsächlich von den Beschichtungsvorgängen in den nachfolgenden Beschichtungssektionen 7, 8 bestimmt ist. Wird einen geringere Bandgeschwindigkeit gefahren, muss auch die Leistungsdichte niedriger eingestellt werden, wogegen bei einer höheren Bandgeschwindigkeit, beispielsweise von 1,8 m/min, dementsprechend die Leistungsdichte in einem oberen Bereich von ca. 0,2 W/cm² liegen kann.

In der zweiten Behandlungssektion 6 ist eine Linear-Ionenquelle 16 zur Erzeugung eines Ionenstrahls 17 installiert, wobei sich die Linear-Ionenquelle 16, in der ein Plasmagenerator 18 mit einem längserstreckten Magnetron integriert ist, senkrecht zur Zeichnungsebene erstreckt, so dass die Linear-Ionenquelle 16 quer zur Transportrichtung 10 der Kunststofffolienbahn 2 angeordnet ist. Das in den Plasmagenerator 18 eingeleitete Arbeitsgas Argon wird ionisiert, beschleunigt und zu einem energiereichen Ionenstrahl 17 ausgebildet, der auf die Oberfläche der Polyimidfolie 2 gerichtet ist. Mit dem Auftreffen der Ionen wird die Oberfläche durch den Energieeintrag aktiviert. Zur Bildung eines hochenergetischen Ionenstrahls wird der Plasmagenerator 18 mit einem Spannungspotential von 3 kV bei einem Stromfluss von bis zu 3,0 A betrieben, wobei der Gasvolumenstrom des Arbeitsgases Argon in der Ionenquelle 16 auf 20 sccm eingestellt ist. Dem Ionenstrahl 17 wird zur Erzeugung einer geeigneten reaktiven Atmosphäre in der Behandlungssektion 6 Sauerstoff mit einem Gasvolumenstrom von 200 sccm und Stickstoff mit einem Gasvolumenstrom von 20 sccm zugeleitet, wobei ein Sauerstoffgasdruck in der Behandlungssektion 6 von 3 x 10 ⁻³ mbar eingestellt ist.

In der Vorbehandlungseinheit 4 wird die Polyimidfolie 2 also zunächst einem niederenergetischen, nicht reaktiven Plasma 14 ausgesetzt und anschließend mit einem hochenergetischen Ionenstrahl 17 beschossen, wobei keine Beschichtungsvorgänge stattfinden.

In der ersten Beschichtungssektion 7 nachfolgend zur Vorbehandlungseinheit 4 befindet sich eine Sputtereinrichtung 19 mit einem Magnetron, das eine Kathode 20 mit beispielsweise einem NiCr-Target aufweist, mit der eine erste Schicht, nämlich eine Haftvermittlerschicht aus Nickelchrom (NiCr) auf die zuvor in der Vorbehandlungseinheit 4 vorbehandelte Polyimidfolie 2 aufgesputtert wird. Dabei beträgt die Kathodenleistung 2,0 kW. Die Haftvermittlerschicht wird mit einer Dicke von 10 µm auf die Polyimidfolie 2 aufgetragen. Diese Haftvermittelschicht dient neben der Haftvermittelung zwischen der Polyimidfolie 2 und der nachfolgenden Schicht auch als Ätzstoff, um den außerhalb der Bandbeschichtungsanlage 1 stattfindenden Ätzprozess zur Herstellung der Schaltungsstrukturen auf der Polyimidfolie 2 zu unterstützen.

In der in Transportrichtung 10 nachfolgenden zweiten Beschichtungssektion 8 befindet sich eine weitere Sputtereinrichtung 21 mit einem Magnetron, dessen Kathode 22 beispielsweise ein Cu-Target aufweist. Mittels dieser Sputtereinrichtung 21 wird bei einer Kathodenleistung von 20 kW eine Kupferschicht (Cu) mit einer Schichtdicke von 150 nm als folgende Schicht auf die Haftvermittlerschicht aufgesputtert.

Die Sputtervorgänge in beiden Beschichtungssektionen 7, 8 findet jeweils unter einer Argon-Atmosphäre bei einem Gasfluss von 150 sccm und einem Gasdruck von 3 x 10⁻³ mbar statt.

Für die Fertigstellung der Verbundfolie 3 erfolgt meist eine weitere Beschichtung außerhalb der Bandbeschichtungsanlage 1, beispielsweise durch Galvanisierung (elektroplated), wobei z.B. nochmals Kupfer mit einer Schichtdicke von 24 µm aufgebracht wird. Nachfolgend werden sodann die Schaltungsstrukturen eingeätzt.

Mit der verfahrenstechnischen Kombination der vorbeschriebenen Vorbehandlungsmaßnahmen, realisiert in der vorbeschriebenen Bandbeschichtungsanlage 1, werden unter den gewählten Prozessparametern besonders haftfeste Kupfer-Polyimid- Verbundfolien 3 erzielt, die in einem Haftfestigkeitstest (peelstrength test) eine Haftfestigkeit bis zu 14,1 N/cm erreichen. Allerdings ist die Erfindung keinesfalls auf die beschriebenen Schichtenmaterialien beschränkt sondern für die Haftungsverbesserung auch auf andere Schichtfolgen anwendbar.

### Bezugszeichenliste

- 1: Bandbeschichtungsanlage
- 2: Kunststoffsubstrat, Kunststofffolienbahn, Polyimidfolie
- 3: Verbundfolie
- 4: Vorbehandlungseinheit
- 5: erste Behandlungssektion
- 6: zweite Behandlungssektion
- 7: erste Beschichtungssektion
- 8: zweite Beschichtungssektion
- 9: Beschichtungswalze
- 10: Pfeilrichtung, Transportrichtung
- 11: erste Umlenkwalze
- 12: zweite Umlenkwalze
- 13: Glimmentladevorrichtung
- 14: Plasma
- 15: Glimmkathode
- 16: Ionenquelle, Linear-Ionenquelle
- 17: Ionenstrahl, Ionenbestrahlung
- 18: Plasmagenerator mit Magnetron
- 19: Sputtereinrichtung mit Magnetron
- 20: Kathode mit NiCr-Target
- 21: Sputtereinrichtung mit Magnetron
- 22: Kathode mit Cu-Target

## Patentansprüche

1. Verfahren zur Beschichtung eines Kunststoffsubstrates mit mindestens einer Metallschicht, insbesondere Kunststofffolie für flexible, gedruckte Leiterbahnen, wobei vor dem Aufbringen einer ersten Schicht auf eine zu beschichtende Oberfläche des Kunststoffsubstrates eine nicht beschichtende Vorbehandlung dieser Oberfläche vorgenommen wird,
**dadurch gekennzeichnet, dass**
die nicht beschichtende Vorbehandlung in zwei Stufen erfolgt, nämlich in einer ersten Stufe, in der die Oberfläche des Kunststoffsubstrates (2) mit einem nichtreaktiven, energiearmen Plasma (14) gereinigt wird, wobei das Plasma (14) eine Leistungsdichte in einem Bereich von 0,05 bis 1 W/cm² aufweist, und in einer zweiten Stufe, in der die Oberfläche des Kunststoffsubstrates (2) durch eine reaktive, energiereiche Ionenbestrahlung (17) aktiviert wird, wobei die Ionenbestrahlung (17) eine Leistungsdichte in einem Bereich von mehr als 1 bis 10 W/cm² aufweist.

2. Verfahren nach Anspruch 1,
**dadurch gekennzeichnet, dass**
als nichtreaktives Plasma (14) ein ionisiertes Edelgas, vorzugsweise Argon, verwendet wird.

3. Verfahren nach Anspruch 1 oder 2,
**dadurch gekennzeichnet, dass**
das Plasma (14) durch eine Glimmentladung (13) erzeugt wird, die mit einem Spannungspotential von 0,1 kV bis 1 kV betrieben wird.

4. Verfahren nach einem der Ansprüche 1 bis 3,
**dadurch gekennzeichnet, dass**
die Ionenbestrahlung (17) eine Leistungsdichte in einem Bereich von mehr als 1 bis 5 W/cm², vorzugsweise in einem Bereich von mehr als 1 bis 3 W/cm² aufweist.

5. Verfahren nach einem der Ansprüche 1 bis 4,
**dadurch gekennzeichnet, dass**
die Ionenbestrahlung (17) durch eine Ionenquelle (16) erzeugt wird, die mit einem Spannungspotential von ≥1kV, insbesondere 1kV bis 3 kV betrieben wird.

6. Verfahren nach Anspruch 5,
**dadurch gekennzeichnet, dass**
als Arbeitsgas der Ionenquelle (16) Argon verwendet wird.

7. Verfahren nach einem der Ansprüche 1 bis 6,
**dadurch gekennzeichnet, dass**
die reaktive Atmosphäre der Ionenbestrahlung (17) durch Zufuhr eines Reaktionsgases aus Sauerstoff und/oder Stickstoff erzeugt wird.

8. Verfahren nach einem der Ansprüche 5 bis 7,
**dadurch gekennzeichnet, dass**
die Ionenquelle (16) einen bandartigen Ionenstrahl (17) erzeugt, der derart fokussiert wird, dass der Ionenstrahl (17) in einer Linie auf die Oberfläche des Kunststoffsubstrates (2) auftrifft.

9. Verfahren nach Anspruch 8,
**dadurch gekennzeichnet, dass**
die lineare Projizierung des Ionenstrahls (17) auf der Oberfläche des Kunststoffsubstrates (2) quer zu einer Transportrichtung (10) des Kunststoffsubstrates (2) erfolgt.

10. Verfahren nach einem der vorhergehenden Ansprüche,
**dadurch gekennzeichnet, dass**
als Kunststoffsubstrat (2) eine Folie (2) aus Polyester (PET), Polyäthylen (PE), Polypropylen (PP) und/oder aus Polyamid (PA), vorzugsweise aus Polyimid, verwendet wird.

11. Verfahren nach Anspruch 10,
**dadurch gekennzeichnet, dass**
die Folie (2) eine Foliendicke vorzugsweise in einem Bereich von 12,5 µm bis 50 µm aufweist.

12. Verfahren nach einem der vorhergehenden Ansprüche,
**dadurch gekennzeichnet, dass**
nach der Vorbehandlung eine erste Schicht als Haftvermittlerschicht durch Aufsputtern auf die Oberfläche des Kunststoffsubstrates (2) aufgebracht wird, wobei als Schichtmaterial vorzugsweise Chrom (Cr), Nickel(Ni), Nickelchrom (NiCr) oder Chromtitan (CrTi) verwendet wird.

13. Verfahren nach Anspruch 12,
**dadurch gekennzeichnet, dass**
die Haftvermittlerschicht mit einer Schichtdicke vorzugsweise in einem Bereich von 2 nm bis 40 nm ausgebildet wird.

14. Verfahren nach einem der Ansprüche 12 oder 13,
**dadurch gekennzeichnet, dass**
nach dem Aufsputtern der Haftvermittlerschicht eine Metallschicht aus vorzugsweise Kupfer oder Kupferlegierung, aufgesputtert wird.

15. Verfahren nach Anspruch 14,
**dadurch gekennzeichnet, dass**
die Metallschicht mit einer Schichtdicke vorzugsweise in einem Bereich von 150 µm bis 300 µm ausgebildet wird.

16. Bandbeschichtungsanlage zur Beschichtung einer Kunststofffolienbahn mit mindestens einer Metallschicht, insbesondere für flexible, gedruckte Leiterbahnen, wobei eine Vorbehandlungseinheit für eine nicht beschichtende Vorbehandlung einer Oberfläche der Kunststofffolienbahn vorgesehen ist, die in Transportrichtung der Kunststofffolienbahn durch die Bandbeschichtungsanlage einer ersten Beschichtungssektion vorgeordnet ist,
**dadurch gekennzeichnet, dass**
die Vorbehandlungseinheit (4) eine erste Behandlungssektion (5) zur Reinigung der Oberfläche der Kunststofffolienbahn (2) mit einem nichtreaktiven, energiearmen Plasma (14) mit einer Leistungsdichte in einem Bereich von 0,05 bis 1 W/cm² aufweist, und eine in Transportrichtung (10) nachfolgende zweite Behandlungssektion (6) zur Aktivierung der Oberfläche der Kunststofffolienbahn (2) mit einem reaktiven, energiereichen Ionenstrahl (17) mit einer Leistungsdichte in einem Bereich von mehr als 1 bis 10 W/cm² aufweist.

17. Bandbeschichtungsanlage nach Anspruch 16,
**dadurch gekennzeichnet, dass**
die erste Behandlungssektion (5) eine Glimmentladevorrichtung (13) zur Erzeugung des Plasmas (14), insbesondere ein Magnetron mit einer Glimmkathode (15), aufweist.

18. Bandbeschichtungsanlage nach Anspruch 17,
**dadurch gekennzeichnet, dass**
die Glimmentladevorrichtung (13) mit einem Spannungspotential von 0,1 kV bis 1 kV betreibbar ist.

19. Bandbeschichtungsanlage nach einem der Ansprüche 16 bis 18,
**dadurch gekennzeichnet, dass**
die zweite Behandlungssektion (6) eine Ionenquelle (16) zur Erzeugung eines Ionenstrahls (17) aufweist, in der ein Plasmagenerator (18) mit einem Magnetron vorgesehen ist.

20. Bandbeschichtungsanlage nach Anspruch 19,
**dadurch gekennzeichnet, dass**
der Plasmagenerator (18) mit einem Spannungspotential von 1 kV bis 3 kV betreibbar ist.

21. Bandbeschichtungsanlage nach einem der Ansprüche 19 oder 20,
**dadurch gekennzeichnet, dass**
die Ionenquelle (16) eine Linear-Ionenquelle (16) ist, mit welcher ein bandartig geformter Ionenstrahl (17) in einer Linie auf die Oberfläche der Kunststofffolienbahn (2) fokussierbar ist.

22. Bandbeschichtungsanlage nach Anspruch 21,
**dadurch gekennzeichnet, dass**
die Linear-Ionenquelle (16) quer zur Transportrichtung (10) der Kunststofffolienbahn (2) angeordnet ist.

23. Bandbeschichtungsanlage nach einem der Ansprüche 16 bis 22,
**dadurch gekennzeichnet, dass**
die erste Beschichtungssektion (7) eine Sputtereinrichtung (19) zum Aufsputtern einer Haftvermittlerschicht aus vorzugsweise Chrom (Cr), Nickel(Ni), Nickelchrom (NiCr) oder Chromtitan (CrTi) aufweist.

24. Bandbeschichtungsanlage nach Anspruch 23,
**dadurch gekennzeichnet, dass**
eine in Transportrichtung (10) nachfolgende zweite Beschichtungssektion (8) eine Sputtereinrichtung (21) zum Aufsputtern einer Metallschicht aus vorzugsweise Kupfer oder Kupferlegierung, aufweist.

## Claims

1. A process for depositing a plastic substrate with at least one metal layer, in particular plastic foil for flexible, printed circuit boards, wherein a non depositing pretreatment of the surface is performed before depositing a first layer onto the surface of the plastic substrate to be deposited,
**characterized in that,**
the non depositing pretreatment is performed in two steps, thus in a first step, in which the surface of the plastic substrate (2) is cleaned with a non reactive low energy plasma (14), wherein the plasma (14) has a power density in a range of 0.05 to 1 W/cm², and in a second step, in which the surface of the plastic substrate (2) is activated through a reactive high energy ion radiation (17), wherein the ion radiation (17) has a power density in a range of more than 1 to 10 W/cm².

2. A process according to claim 1,
**characterized in that,**
an ionized noble gas, preferably argon, is used as non reactive plasma (14).

3. A process according to claim 1 or 2,
**characterized in that,**
the plasma (14) is generated through a glow discharge (13), which is operated with a voltage potential of 0.1 kV to 1 kV.

4. A process according to one of the claims 1 to 3,
**characterized in that,**
the ion radiation (17) has a power density in a range of more than 1 to 5 W/cm², preferably in a range of more than 1 to 3 W/cm².

5. A process according to one of the claims 1 to 4,
**characterized in that,**
the ion radiation (17) is generated by an ion source (16), which is operated with a voltage potential of ≥ 1 kV, in particular 1 kV to 3 kV.

6. A process according to claim 5,
**characterized in that,**
argon is used as process gas for the ion source (16).

7. A process according to one of the claims 1 to 6,
**characterized in that,**
the reactive atmosphere of the ion radiation (17) is generated through induction of a reactive gas comprising oxygen and/or nitrogen.

8. A process according to one of the claims 5 to 7,
**characterized in that,**
the ion source (16) generates a band shaped ion beam (17), which is being focused, so that the ion beam (17) hits the surface of the plastic substrate (2) in a line.

9. A process according to claim 8,
**characterized in that,**
the linear projection of the ion beam (17) onto the surface of the plastic substrate (2) is performed perpendicular to the transport direction (10) of the plastic substrate (2).

10. A process according to one of the preceding claims,
**characterized in that,**
a foil (2) made from polyester (PET), polyethylene (PE), polypropylene (PP), and/or polyamide (PA), preferably polyimide, is used as plastic substrate (2).

11. A process according to claim 10,
**characterized in that,**
the foil (2) has a foil thickness, preferably in a range of 12.5 µm to 50 µm.

12. A process according to one of the preceding claims,
**characterized in that,**
after the pretreatment, a first layer is deposited onto the surface of the plastic substrate (2) as an adhesion enhancement layer through sputtering, wherein preferably chromium (Cr), nickel (Ni), nickel chromium (NiCr), or chromium titanium (CrTi) are being used as layer materials.

13. A process according to claim 12,
**characterized in that,**
the adhesion enhancement layer is preferably formed with a layer thickness in a range of 2 nm to 40 nm.

14. A process according to one of the claims 12 or 13,
**characterized in that,**
after sputtering on the adhesion enhancement layer, a metal layer, preferably made from copper or copper alloy, is sputtered on.

15. A process according to claim 14,
**characterized in that,**
the metal layer is preferably formed with a layer thickness of 150 µm to 300 µm.

16. A web deposition machine for depositing a plastic foil web with at least one metal layer, in particular for flexible, printed circuit boards, wherein a pretreatment unit for a non depositing pretreatment of a surface of the plastic foil web is provided, which is placed in front of the first deposition section in transport direction of the plastic web through the web deposition machine,
**characterized in that,**
the pretreatment unit (4) has a first treatment section (5) for cleaning the surface of the plastic foil web (2) with a non reactive, low energy plasma (14) with a power density in a range of 0.05 to 1 W/cm² and a second treatment section (6) following in transport direction (10), for activating the surface of the plastic foil web (2) with a reactive high energy ion beam (17) having a power density in a range of more than 1 to 10 W/cm²_{.}

17. A web deposition machine according to claim 16,
**characterized in that,**
the first treatment section (5) has a glow discharge device (13) for generating the plasma (14), in particular a magnetron with a glow cathode (15).

18. A web deposition machine according to claim 17,
**characterized in that,**
the glow discharge device (13) can be operated with a voltage potential of 0.1 kV to 1 kV.

19. A web deposition machine according to one of the claims 16 to 18,
**characterized in that,**
the second treatment section (6) has an ion source (16) for generating an ion beam (17), in which a plasma generator (18) with a magnetron is provided.

20. A web deposition machine according to claim 19,
**characterized in that,**
the plasma generator (18) can be operated with a voltage potential of 1 kV to 3 kV.

21. A web deposition machine according to one of the claims 19 or 20,
**characterized in that,**
the ion source (16) is a linear ion source (16), through which a band shaped ion beam (17) can be focused in a line onto the surface of the plastic foil (2).

22. A web deposition machine according to claim 21,
**characterized in that,**
the linear ion source (16) is disposed perpendicular to the transport direction (10) of the plastic foil (2).

23. A web deposition machine according to one of the claims 16 to 22,
**characterized in that,**
the first deposition section (7) has a sputter assembly (19) for sputtering an adhesion enhancement layer, preferably made from chromium (Cr), nickel (Ni), nickel chromium (NiCr), or chromium titanium (CrTi).

24. A web deposition machine according to claim 23,
**characterized in that,**
a second deposition section (8) following in transport direction (10) has a sputter assembly (21) for sputtering a metal layer, preferably from copper or copper alloy.

## Revendications

1. Procédé de revêtement d'un substrat en matière plastique d'au moins une couche métallique, en particulier feuille en matière plastique pour des pistes conductrices imprimées flexibles, avant l'application d'une première couche sur une surface à revêtir dudit substrat en matière plastique étant procédé à un traitement préalable de cette surface qui ne procure pas de revêtement, **caractérisé par le fait que** le traitement préalable ne procurant pas de revêtement étant mis en oeuvre en deux étapes, à savoir en une première étape dans laquelle la surface dudit substrat en matière plastique (2) est nettoyée au moyen d'un plasma non réactif pauvre en énergie (14), ledit plasma (14) présentant une densité de puissance comprise entre 0,05 et 1 W/cm², et en une deuxième étape dans laquelle la surface du substrat en matière plastique (2) est activée par une irradiation ionique réactive riche en énergie (17), ladite irradiation ionique (17) présentant une densité de puissance comprise entre plus de 1 et 10 W/cm².

2. Procédé selon la revendication 1, **caractérisé par le fait que** l'on utilise en tant que plasma non réactif (14) un gaz rare ionisé, de préférence de l'argon.

3. Procédé selon la revendication 1 ou 2, **caractérisé par le fait que** ledit plasma (14) est généré par une décharge luminescente (13) qui est opérée à un potentiel de tension compris entre 0,1 kV et 1 kV.

4. Procédé selon l'une quelconque des revendications 1 à 3, **caractérisé par le fait que** ladite irradiation ionique (17) présente une densité de puissance comprise entre plus de 1 et 5 W/cm², de préférence entre plus de 1 et 3 W/cm².

5. Procédé selon l'une quelconque des revendications 1 à 4, **caractérisé par le fait que** l'irradiation ionique (17) est générée par une source d'ions (16) qui est opérée à un potentiel de tension de ≥ 1 kV, en particulier compris entre 1 kV et 3 kV.

6. Procédé selon la revendication 5, **caractérisé par le fait que** l'on utilise de l'argon en tant que gaz de travail de la source d'ions (16).

7. Procédé selon l'une quelconque des revendications 1 à 6, **caractérisé par le fait que** l'atmosphère réactive de l'irradiation ionique (17) est générée en amenant un gaz de réaction en oxygène et/ou en azote.

8. Procédé selon l'une quelconque des revendications 5 à 7, **caractérisé par le fait que** ladite source d'ions (16) génère un faisceau ionique de type bande (17) qui est focalisé de telle manière que le faisceau ionique (17) rencontre la surface du substrat en matière plastique (2) sur une ligne.

9. Procédé selon la revendication 8, **caractérisé par le fait que** la projection linéaire du faisceau ionique (17) sur la surface du substrat en matière plastique (2) se fait transversalement à une direction de transport (10) du substrat en matière plastique (2).

10. Procédé selon l'une quelconque des revendications précédentes, **caractérisé par le fait que** l'on utilise une feuille (2) en polyester (PET), polyéthylène (PE), polypropylène (PP) et/ou en polyamide (PA), de préférence en polyimide, en tant que substrat en matière plastique (2).

11. Procédé selon la revendication 10, **caractérisé par le fait que** ladite feuille (2) présente une épaisseur de feuille comprise de préférence entre 12,5 µm et 50 µm.

12. Procédé selon l'une quelconque des revendications précédentes, **caractérisé par le fait que**, après le traitement préalable, une première couche est appliquée par pulvérisation cathodique en tant que couche d'accrochage sur la surface du substrat en matière plastique (2), la matière de la couche utilisée de préférence étant le chrome (Cr), le nickel (Ni), le nickel-chrome (NiCr) ou le chrome-titane (CrTi).

13. Procédé selon la revendication 12, **caractérisé par le fait que** l'épaisseur de couche de la couche d'accrochage réalisée est comprise de préférence entre 2 nm et 40 nm.

14. Procédé selon l'une quelconque des revendications 12 ou 13, **caractérisé par le fait que**, après avoir appliqué par pulvérisation cathodique ladite couche d'accrochage, une couche de métal de préférence en cuivre ou en alliage de cuivre est appliquée par pulvérisation cathodique.

15. Procédé selon la revendication 14, **caractérisé par le fait que** l'épaisseur de couche de ladite couche métallique réalisée est comprise de préférence entre 150 µm et 300 µm.

16. Installation de revêtement de bandes pour revêtir une bande de feuille en matière plastique d'au moins une couche métallique, en particulier pour pistes conductrices imprimées flexibles, dans laquelle est prévue une unité de traitement préalable pour un traitement préalable d'une surface de la bande de feuille en matière plastique, qui ne procure pas de revêtement, ladite unité de traitement préalable étant placée - dans la direction de transport de la bande de feuille en matière plastique à travers l'installation de revêtement de bandes - en amont d'une première section de revêtement, **caractérisée par le fait que** ladite unité de traitement préalable (4) comprend une première section de traitement (5) pour nettoyer la surface de la bande de feuille en matière plastique (2) au moyen d'un plasma non réactif pauvre en énergie (14) ayant une densité de puissance comprise entre 0,05 et 1 W/cm², ainsi qu'une deuxième section de traitement (6) qui, vu dans la direction de transport (10), suit ladite première et qui est destinée à activer la surface de ladite bande de feuille en matière plastique (2) par un faisceau ionique réactif riche en énergie (17) présentant une densité de puissance comprise entre plus de 1 et 10 W/cm².

17. Installation de revêtement de bandes selon la revendication 16, **caractérisée par le fait que** ladite première section de traitement (5) présente un dispositif de décharge luminescente (13) pour générer le plasma (14), en particulier un magnétron avec une cathode froide (15).

18. Installation de revêtement de bandes selon la revendication 17, **caractérisée par le fait que** ledit dispositif de décharge luminescente (13) peut être opéré à un potentiel de tension compris entre 0,1 kV et 1 kV.

19. Installation de revêtement de bandes selon l'une quelconque des revendications 16 à 18, **caractérisée par le fait que** ladite deuxième section de traitement (6) présente une source d'ions (16) destinée à générer un faisceau ionique (17), à l'intérieur de laquelle est prévu un générateur de plasma (18) avec un magnétron.

20. Installation de revêtement de bandes selon la revendication 19, **caractérisée par le fait que** ledit générateur de plasma (18) peut être opéré à un potentiel de tension compris entre 1 kV et 3 kV.

21. Installation de revêtement de bandes selon l'une quelconque des revendications 19 ou 20, **caractérisée par le fait que** ladite source d'ions (16) est une source d'ions linéaire (16) à l'aide de laquelle un faisceau ionique (17) formé à la manière d'une bande peut être focalisé sur une ligne sur la surface de la bande de feuille en matière plastique (2).

22. Installation de revêtement de bandes selon la revendication 21, **caractérisée par le fait que** ladite source d'ions linéaire (16) est disposée transversalement à la direction de transport (10) de la bande de feuille en matière plastique (2).

23. Installation de revêtement de bandes selon l'une quelconque des revendications 16 à 22, **caractérisée par le fait que** la première section de revêtement (7) comprend un dispositif de pulvérisation cathodique (19) destiné à appliquer par pulvérisation cathodique une couche d'accrochage de préférence en chrome (Cr), nickel (Ni), nickel-chrome (NiCr) ou en chrome-titane (CrTi).

24. Installation de revêtement de bandes selon la revendication 23, **caractérisée par le fait qu'**une deuxième section de revêtement (8) qui, vu dans la direction de transport (10), suit ladite première, comprend un dispositif de pulvérisation cathodique (21) pour appliquer par pulvérisation cathodique une couche métallique de préférence en cuivre ou en alliage de cuivre.
